Europäisches Patentamt

European Patent Office

Office européen des brevets

(19)

(11) Veröffentlichungsnummer: **0 268 203**
**A2**

(12) # EUROPÄISCHE PATENTANMELDUNG

(21) Anmeldenummer: 87116663.3

(22) Anmeldetag: 11.11.87

(51) Int. Cl.⁴ **G03F 7/20**

(30) Priorität: 18.11.86 DE 3639346

(43) Veröffentlichungstag der Anmeldung:
25.05.88 Patentblatt 88/21

(84) Benannte Vertragsstaaten:
DE FR GB NL

(71) Anmelder: **Siemens Aktiengesellschaft Berlin und München**
**Wittelsbacherplatz 2**
**D-8000 München 2(DE)**

(72) Erfinder: **Müller, Karl-Heinz, Dr.**
**Holtheimer Weg 9**
**D-1000 Berlin 45(DE)**

(54) **Verfahren und Anordnung zur Änderung des Abbildungsmassstabes in der Röntgenlithografie.**

(57) Es ist bekannt, den Abbildungsmaßstab in lithografischen Anordnungen mit punktförmigen Quellen durch Änderung des Abstandes (P) zwischen Maske (M) und Halbleiterscheibe (W) zu variieren. Dieses Verfahren ist in der Röntgenlithografie mit Synchrotonstrahlung nicht anwendbar. Erfindungsgemäß wird deshalb vorgeschlagen, den zu strukturierenden Oberflächenbereich der Halbleiterscheibe (W) während der Belichtung durch Ansaugen an eine entsprechend ausgebildete Halterung (H) kugel-oder zylinderförmig zu deformieren.

FIG 1

EP 0 268 203 A2

# Verfahren und Anordnung zur Änderung des Abbildungsmaßstabes in der Röntgenlithografie

Die Erfindung bezieht sich auf ein Verfahren und eine Anordnung zur Änderung des Abbildungsmaßstabes in der Röntgenlithografie nach den Oberbegriffen der Patentansprüche 1, 18 und 22.

Die fortschreitende Miniaturisierung mikroelektronischer Bauelemente stellt höchste Anforderungen an die Leistungsfähigkeit der lithografischen Verfahren. So ist man heute in der Lage mit den in der VLSI-Fertigung vorwiegend eingesetzten lichtoptischen Projektionsverfahren Strukturen mit Abmessungen im Mikrometerbereich (d = 2 - 4 μm) routinemäßig zu erzeugen. Eine weitere Verbesserung dieser lichtoptischen Verfahren, beispielsweise durch den Einsatz von kurzwelligem UV-Licht ($\lambda \approx$ 200 - 300 nm) ist nur noch unter großen technischen Schwierigkeiten möglich, so daß die theoretische Auflösungsgrenze von etwa 0,5 - 0,8 μm kaum erreicht werden dürfte. Zur Erzeugung von Strukturen im Submikrometerbereich ist man deshalb gezwungen neue Lithografieverfahren zu entwickeln (siehe beispielsweise H. Schaumburg "Neue Lithografieverfahren in der Halbleitertechnik" Elektronik 1978, Heft 11, Seiten 59 - 66). Besondere Bedeutung haben hierbei röntgenlithografische Verfahren erlangt, deren Auflösung wegen der kurzen Wellenlänge der Strahlung ($\lambda \approx$ 0,5 - 4 nm) nicht durch Beugungseffekte, sondern durch die Reichweite der aus der zu strukturierenden Schicht ausgelösten Elektronen im Photolack begrenzt wird. Röntgenlithografiegeräte mit konventionellen Strahlungsquellen zur Ganzscheibenbelichtung von Wafern sind beispielsweise aus der Veröffentlichung von J. Lyman "Lithography steps ahead to meet VLSI challenge" Electronics, Juli 1983, Seite 121-28 bekannt. In diesen Geräten erfolgt die Übertragung vorgegebener Strukturen auf die Halbleiterscheibe durch eine Schattenabbildung, indem man die justierten Masken-Wafer-Paare mit der von einer nahezu punktförmigen Quelle ausgehenden Röntgenstrahlung belichtet. Die einer Kegelprojektion entsprechende Abbildung der Maskenstruktur auf die Waferoberfläche erfolgt mit einem Vergrößerungsmaßstab M = 1 : (1 + P/L), der durch den Abstand P (P $\approx$ 30 μm) zwischen Maske und Wafer und dem Abstand L (L $\approx$ 30 cm) zwischen Röntgenquelle und Wafer definiert ist. Die während des Herstellungsprozesses infolge thermischer Ausdehung und Verspannung auftretenden Änderungen der Sollgröße von Maske und Wafer können bei der Kegelprojektion in einfacher Weise kompensiert werden, in dem man den Abbildungsmaßstab durch Änderungen des sog. Proximity-Abstandes P entsprechend anpaßt. Diese bekannte Methode versagt allerdings, wenn man Elektronensynchrotons bzw. Elektronenspeicherringe als intensitätsstarke Röntgenquellen einsetzt. Wegen des hohen Kollimationsgrades der von den auf Kreisbahnen umlaufenden Elektronen emittierten Synchrotonstrahlung erfolgt die Belichtung des in mehreren Metern Abstand von der Quelle (Speicherring) angeordneten Masken-Wafer-Paares mittels einer nahezu exakten Parallelprojektion (L $\approx$ $\infty$ ). Um auch in der Synchrotonlithografie hohen Überdeckungsgrad (Overlay) zu gewährleisten muß sichergestellt sein, daß Größenänderungen von Maske und Wafer durch Anpassung des Abbildungsmaßstabes kompensiert werden können.

Der Erfindung liegt die Aufgabe zugrunde ein Verfahren und eine Anordnung der eingangs genannten Art anzugeben, mit denen Änderungen des Abbildungsmaßstabes in der Synchrotonlithografie vorgenommen werden können.

Diese Aufgabe wird erfindungsgemäß durch ein Verfahren nach Anspruch 1 und Anordnungen nach den Ansprüchen 18 und 23 gelöst.

Der mit der Erfindung erzielbare Vorteil besteht insbesondere darin, daß Änderungen der Sollgröße von Maske und Wafer durch Anpassung des Abbildungsmaßstabes kompensiert werden können.

Während die Ansprüche 2 bis 17 bevorzugte Ausgestaltungen des Verfahrens nach Anspruch 1 betreffen, sind die Ansprüche 19 bis 22 auf vorteilhafte Weiterbildungen der Anordnung nach Anspruch 18 gerichtet.

Die Erfindung wird im folgenden anhand der Zeichnung erläutert.

Dabei zeigt:

Fig. 1 eine erfindungsgemäße Anordnung zur Änderung des Abbildungsmaßstabes in der Röntgenlithografie mit Synchrotonstrahlung,

Fig. 2 eine erfindungsgemäß ausgebildete Halbleiterscheibe,

Fig. 3 eine Anordnung zur Belichtung großer Halbleiterscheiben nach einem Step und Repeat-Verfahren.

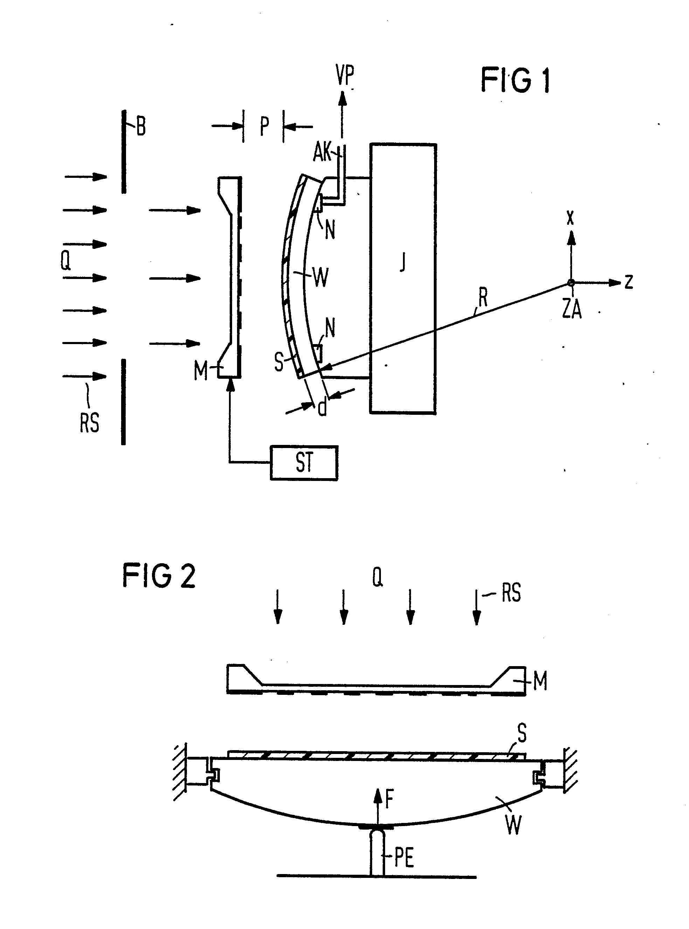

Die in Fig. 1 schematisch dargestellte Anordnung zur Strukturierung eines Objektes besteht im wesentlichen aus einer Strahlungsquelle Q, einer die gewünschte Struktur tragenden Maske M, einer Justiereinheit J und einer mit einer strahlungsempfindlichen Schicht S bedeckten Halbleiterscheibe W, die mit Hilfe der Justiereinheit J in einem vorgegebenen Abstand P zur Maske M positioniert und relativ zu dieser ausgerichtet wird. Als Strahlungsquelle Q für die Röntgenlithografie kommen insbesondere Speicherringe oder Ringbeschleuniger in Betracht, in denen man die von hochrelativistischen Elektronen tangential zur Umlaufbahn emittierte Synchrotonstrahlung RS über vakuumdichte Fenster in den Wandungen des Beschleunigerrings auskoppelt und der jeweiligen Experimentiereinrichtung zuführt. Die Wellenlänge der Synchrotonstrahlung RS kann man hierbei durch geeignete Wahl der Maschinenparameter (Elektronenenergie, Krümmungsradius etc.) über einen großen Bereich kontinuierlich variieren ($0{,}1 \leq \lambda_s \leq 100$ nm), wobei das Muster der mehrere Meter vom Strahlführungsrohr des Beschleunigers entfernten Maske M wegen des hohen Kollimationsgrades des ausgekoppelten Röntgenlichtes RS mittels einer nahezu exakten Parallelprojektion auf die Halbleiterscheibe W abgebildet wird. Ein weiterer Vorteil der Synchrotonstrahlung ist deren hohe Intensität, die sehr kurze Belichtungszeiten (einige Sekunden) ermöglicht. Wegen der begrenzten Homogenität der Strahlung in der zur Bahnebene der Elektronen senkrechten Richtung ist man allerdings gezwungen, den Strahlquerschnitt bandförmig zu begrenzen.

Die von der Quelle Q ausgehende und durch ein Blendensystem B geformte Synchrotonstrahl RS wird üblicherweise in einem evakuierten Strahlrohr an das Lithografiegerät herangeführt, und trifft innerhalb einer in Fig. 1 nicht dargestellten Kammer auf die in bekannter Weise ausgebildete Maske M (siehe beispielsweise H. Lüthje "X-ray lithography for VLSI" Philips Techn. Rev. 41, 1983/84 Nr. 5, Seite 150-163). Die Maske M besteht im allgemeinen aus einer strahlungsundurchlässigen Haltemembran mit verstärkter Berandung und einer strahlungsdurchlässigen Metallschicht, die entsprechend dem auf die Halbleiterscheibe W zu übertragenden Muster strukturiert ist. Weiterhin befinden sich auf der Maske M Marken, die während des Ausrichtens optisch abgetastet und mit Hilfe einer Steuereinheit ST durch Verschieben der Maske M relativ zur Halbleiterscheibe W in die gewünschte Sollposition gebracht werden können.

Wegen des hohen Kollimationsgrades der Synchrotonstrahlung sind die aus dem Bereich der Lithografie mit punktförmigen Röntgenquellen bekannten Verfahren zur Änderung des Abbildungsmaßstabes in der in Fig. 1 dargestellten Anordnung nicht anwendbar. Erfindungsgemäß wird deshalb vorgeschlagen, die Halbleiterscheibe W zumindest in dem zu belichtenden Bereich zu deformieren und den an den jeweiligen Oberflächenpunkten durch Deformation erzeugten Krümmungsradius R während der Bestrahlung konstant zu halten. So erreicht man durch eine kugelförmige Deformation der Halbleiterscheiben W eine Vergrößerung der der Maske M gegenüberliegenden Oberfläche in zwei zueinander orthogonalen Richtungen die zu einer entsprechenden Maßstabsänderung $\epsilon$ in diesen Richtungen führt. Die Größe $\epsilon$ ist hierbei durch den Quotienten $\epsilon = \Delta L / L$ definiert, wobei L eine charakteristische Länge und $\Delta L$ die durch Abbildung erzeugte Änderung dieser Länge bezeichnet. Die Maßstabsänderung beruht auf einen Projektionseffekt (Abbildung der ebenen Maskenstruktur auf eine gekrümmte Fläche) und einer den kleineren Beitrag liefernden Streckung des Halbleitermaterials. Eine zylinderförmige Verspannung des zu belichtenden Objektes erfordert einen geringen Kräfteaufwand und ist insbesondere für Halbleiterscheiben technisch einfacher zu realiseren. Die Maßstabsänderung erfolgt in diesem Fall in der zur Symmetrieachse ZA des Zylinders senkrechten Richtung (x-Richtung in Fig. 1) und beträgt $\epsilon x$ = d/2R, wobei d die Dicke der Halbleiterscheibe W und R den durch Deformation erzeugten Krümmungsradius bezeichnet. Bei einer Dicke d = 0,6 mm und einer in konventionellen Anordnungen üblicherweise geforderten Maßstabsänderung von $\epsilon$ = $10^{-5}$ ergibt sich somit ein technisch ohne weiteres zu realisierender Krümmungsradius von R = 30 m.

Bei dem in Fig. 1 dargestellten Ausführungsbeispiel einer erfindungsgemäßen Anordnung zur Änderung des Abbildungsmaßstabes erfolgt die Deformation des zu struk turierenden Oberflächenbereiches mit Hilfe einer zwischen Halbleiterscheibe W und Justiereinheit J angeordneten Halterung H, deren Oberfläche auf der der Maske M zugewandten Seite entsprechend dem einzustellenden Krümmungsradius R kugel-oder zylinderförmig ausgebildet ist. In die Oberfläche dieser Halterung H sind hierbei eine oder mehrere, vorzugsweise ringförmige Nuten N eingelassen, die über Kanäle AK mit einer in Fig. 1 nicht dargestellten Vakuumpumpe VP verbunden sind, so daß sich die gewünschte Oberflächendeformation durch Ansaugen der Halbleiterscheibe W selbsttätig einstellt (statische Deformation). Eine zylinderförmige Deformation der Halbleiterscheibe W kann auch durch eine auf deren Rückseite in einem oder mehreren Punkten bzw. entlang einer Linie angreifenden Kraft F erreicht werden (siehe Fig. 2). Diese Kraft F erzeugt man vorzugsweise mit Hilfe piezoelektrischer Elemente PE, die die an den Rändern gehalterte Halbleiterscheibe W an deren Mittelpunkt bzw. entlang einer durch den Mittelpunkt gehenden Linie abstützen (dynamische Deformation). Um eine über einen größeren Oberflächenbereich zylinderförmige Deformation zu gewährleisten verwendet man vorzugsweise Halbleiterscheiben W mit einer auf der der Maske M zugewandten Seite ebenen und einer auf der der Maske M abgewandten Seite konvexen Oberfläche, wobei die Scheibendicke vom Rand zur Mitte hin stetig anwächst.

Gemäß weiterer Erfindung kann die Halbleiterscheibe W auch von einem Behälter mit elastischen Wänden (Ausgleichskissen) gehalten und durch Änderung des Innendruckes des Behälters deformiert werden.

Bei zylinderförmiger Deformation der Halbleiterscheibe W ändert sich der Abbildungsmaßstab bzw. die Vergrößerung $\epsilon$ nur in einer Raumrichtung (in Fig. 1 in x-Richtung mit $\epsilon_x$ = d/2R). Um auch eine Maßstabsänderung in Richtung der Symmetrieachse ZA des Zylinders (y-Richtung in Fig. 1) herbeizuführen wird erfindungsgemäß vorgeschlagen, den nahezu strichförmig ausgeblendeten Synchrotonstrahl RS beispielsweise mit Hilfe eines drehbar gelagerten Spiegels in Richtung der Zylinderachse ZA mit konstanter Geschwindigkeit $v_S$ über die Maske M abzulenken. Anstelle dieser Ablenkung kann man die Maske M und die Halbleiterscheibe W auch gemeinsam durch den feststehenden Strahl ziehen, dessen in Ablenkrichtung bzw. Verschiebungsrichtung gemessene Breite b kleiner als dessen Höhe h ist (z. B. h ≈ 30 mm, b ≈ 3 mm). Verschiebt man nun auch die Maske M mit konstanter Geschwindigkeit $v_M$ gegenüber der Halbleiterscheibe W in Richtung der Zylinderachse ZA, so führt dies zu einer durch das Verhältnis

$$1) \quad \epsilon_y = v_M/v_S$$

gegeben Änderung der Vergrößerung $\epsilon_y$ und damit zu einer Änderung des Abbildungsmaßstabes in dieser Richtung, wobei $\vec{v}_S = v_S \bullet \vec{e}_y$ die Relativgeschwindigkeit des Synchrotonstrahls RS gegenüber der Maske M und $\vec{v}_M = v_M \bullet \vec{e}_y$ die Relativgeschwindigkeit der Maske M gegenüber der Halbleiterscheibe W bezeichnet. Die endliche Breite b des Synchrotonstrahls führt zu einer Auflösungsbegrenzung a = $\epsilon_y \bullet$ b, die für typische Werte von b = 3 mm und $\epsilon_y = 10^{-5}$ bei a = 30 nm liegt.

Das beschriebene Verfahren der zylinderförmigen Deformation in Kombination mit einer Maßstabsänderung durch Relativbewegung hat gegenüber der kugelförmigen Verspannung den Vorteil, daß der Maßstab in orthogonalen Richtungen unabhängig voneinander eingestellt werden kann.

Mit dem erfindungsgemäßen Verfahren sind auch Orthogo-nalitätsfehler der Maske M korrigierbar, wenn man die Maske M zusätzlich noch in der zur Zylinderachse ZA senkrechten Richtung (x-Richtung in Fig. 1) mit konstan ter Geschwindigkeit gegenüber der Halbleiterscheibe W verschiebt.

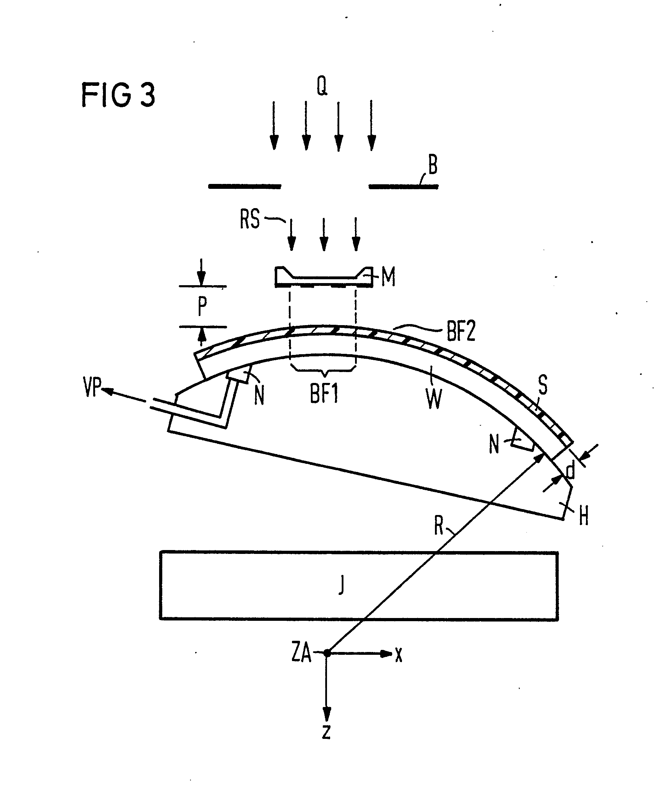

Die Erfindung ist selbstverständlich auch in Synchroton-Steppern anwendbar, in denen man große Halbleiterscheiben mit Durchmessern bis zu 20 cm mit Hilfe eines Step-und Repeat-Verfahrens strukturiert. Bei diesem auch aus der Lithografie mit Elektronenstrahlen bekannten Verfahren wird die Halbleiterscheibe W nacheinander in senkrecht zueinander angeordneten Teilbereichen BF belichtet, deren Größe durch das Maskenfeld (4 × 4 cm) vorgegeben ist. Um auch in Synchroton-Steppern eine über die gesamte Oberfläche der Halbleiterscheibe W konstante, vom Krümmungsradius R und der Scheibendicke d abhängige Maßstabsänderung zu gewährleisten, muß der jeweils zu belichtende Teilbereich BF1, BF2 durch räumliche Verschiebung der Halbleiterscheibe W unmittelbar unterhalb der Maske M positioniert werden (siehe Fig. 3). Hierbei ist darauf zu achten, daß der Mittelpunkt (bei kugelförmiger Deformation) oder die auf einer Geraden durch den Mittelpunkt liegenden Punkte (bei zylinderförmiger Deformation) des jeweiligen Teilbereichs BF1, BF2 den geringsten Abstand P zur Maske M aufweisen. Die mit Hilfe der Justiereinheit J ausgeführte Verschiebung entspricht dann einer virtuellen Drehung der Halbleiterscheibe W um den Mittelpunkt einer Kugel bzw. einer Drehung um die Symmetrieachse ZA eines Zylinders.

**Ansprüche**

1. Verfahren zur Änderung des Abbildungsmaßstabes in der Röntgenlithografie bei dem zumindest ein Teil der Oberfläche eines zu strukturierenden Objektes durch eine dem Objekt vorgelagerte Maske mit kollimierter Röntgenstrahlung beaufschlagt wird, dadurch **gekennzeichnet,** daß das Objekt (W) zumindest in dem zu strukturierenden Bereich deformiert wird, und daß der an den einzelnen Oberflächenpunkten durch Deformation erzeugte Krümmungsradius (R) während der Bestrahlung des Objektes (W) konstant gehalten wird.

2. Verfahren nach Anspruch 1, dadurch **gekennzeichnet,** daß die Oberfläche des Objektes (W) derart deformiert wird, daß der Krümmungsradius (R) zumindest in dem zu strukturierenden Bereich konstant ist.

3. Verfahren nach Anspruch 1 oder 2, dadurch **gekennzeichnet,** daß das Objekt (W) durch Anpressen an eine entsprechend der auszubildenden Krümmung geformten Halterung (H) deformiert wird.

4. Verfahren nach Anspruch 1 oder 2, dadurch **gekennzeichnet,** daß das Objekt (W) an den Rändern gehaltert und durch eine an der der Maske (M) abgewandten Fläche des Objektes (W) angreifenden Kraft (F) deformiert wird.

5. Verfahren nach Anspruch 4, dadurch **gekennzeichnet,** daß die Kraft (F) in einem Punkt angreift.

6. Verfahren nach Anspruch 4, dadurch **gekennzeichnet,** daß die Kraft (F) entlang einer Linie angreift.

7. Verfahren nach Anspruch 1 oder 2, dadurch **gekennzeichnet,** daß das Objekt (W) auf einem Behälter mit elastischen Wandungen gehalten und durch Veränderung des Innendrucks des Behälters deformiert wird.

8. Verfahren nach einem der Ansprüche 1 bis 7, dadurch **gekennzeichnet,** daß Objekte (W) verwendet werden, deren Dicke vom Rand zur Mitte hin stetig anwächst.

9. Verfahren nach einem der Ansprüche 1 bis 8, dadurch **gekennzeichnet,** daß die Oberfläche des zu strukturierenden Objektes (W) kugelförmig deformiert wird.

10. Verfahren nach einem der Ansprüche 1 bis 8, dadurch **gekennzeichnet,** daß das Objekt (W) derart deformiert wird, daß zumindest der zu strukturierende Oberflächenbereich Teil der Mantelfläche eines Zylinders bildet.

11. Verfahren nach Anspruch 10, dadurch **gekennzeichnet,** daß zumindest ein zu strukturierender Oberflächenbereich des Objektes (W) derart zylinderförmig deformiert wird, daß die Symmetrieachse (ZA) des Zylinders in einer senkrecht zur Ausbreitungsrichtung der Strahlung (RS) stehenden Ebene liegt, daß ein Röntgenstrahl (RS) mit rechteckförmigen Querschnitt mit einer ersten Geschwindigkeit ($v_S$) in Richtung der Zylinderachse (ZA) über die Maske (M) abgelenkt wird, wobei die Abmessung des Strahls (RS) in Ablenkrichtung kleiner als in der dazu senkrechten Richtung ist, und daß die Maske (M) mit einer zweiten Geschwindigkeit ($v_M$) in Richtung der Zylinderachse (ZA) gegenüber dem Objekt (W) verschoben wird.

12. Verfahren nach Anspruch 11, dadurch **gekennzeichnet,** daß die Maske (M) zur Korrektur von Orthogonalitätsfehlern mit einer dritten Geschwindigkeit senkrecht zur Zylinderachse (ZA) und senkrecht zur Ausbreitungsrichtung des Röntgenstrahls (RS) gegenüber dem Objekt (W) verschoben wird.

13. Verfahren nach Anspruch 11 oder 12, dadurch **gekennzeichnet,** daß der Röntgenstrahl (RS) mit Hilfe eines Spiegels über die Maske (M) abgelenkt wird.

14. Verfahren nach Anspruch 11 oder 12, dadurch **gekennzeichnet,** daß die Maske (M) und das Objekt (W) gemeinsam durch den Röntgenstrahl (RS) gezogen werden.

15. Verfahren nach einem der Ansprüche 1 bis 14, dadurch **gekennzeichnet,** daß Synchrotonstrahlung zur Strukturierung des Objektes (W) verwendet wird.

16. Verfahren nach einem der Ansprüche 1 bis 15, dadurch **gekennzeichnet,** daß mindestens ein zu strukturierender Oberflächenbereich durch räumliche Verschiebung des Objektes (W) relativ zur Maske (M) in dem durch die Maske (M) vorgegebenen Bestrahlungsfeld (BF1, BF2) positioniert wird.

17. Verfahren nach Anspruch 16, dadurch **gekennzeichnet,** daß die Positionierung derart erfolgt, daß der Mittelpunkt oder die auf einer gerade durch den Mittelpunkt liegenden Punkte des zu strukturierenden Oberflächenbereiches den kleinsten Abstand (P) zur Maske (M) aufweisen.

18. Anordnung zur Änderung des Abbildungsmaßstabes in der Röntgenlithografie mit einer Strahlungsquelle zur Erzeugung kollimierter Röntgenstrahlung mit einer Maske (M), mit einem zu strukturierendes Objekt und eine Justiereinheit zur Positionierung des Objektes in einem Röntgenstrahl und zur Ausrichtung des Objektes relativ zur Maske (M), **gekennzeichnet** durch eine zwischen Objekt (W) und Justiereinheit (J) angeordneten Halterung (H) mit einer auf der dem Objekt (W) zugewandten Seite entsprechend einer vorzunehmenden Deformation gekrümmten Oberfläche und mindestens einer in diese Oberfläche eingelassenen Nut (N), die zum Ansaugen des Objektes (W) mit einer Unterdruckpumpeinrichtung (VP) verbunden ist.

19. Anordnung nach Anspruch 18, dadurch **gekennzeichnet,** daß die Oberfläche der Halterung (H) zylinderförmig ausgebildet ist.

20. Anordnung nach Anspruch 18, dadurch **gekennzeichnet,** daß die Oberfläche der Halterung (H) kugelförmig ausgebildet ist.

21. Anordnung nach einem der Ansprüche 18 bis 20, dadurch **gekennzeichnet,** daß die Nut (N) ringförmig ausgebildet ist.

22. Anordnung zur Änderung des Abbildungsmaßstabes in der Röntgenlithografie mit einer Strahlungsquelle zur Erzeugung kollimierter Röntgenstrahlung, und mit einer Maske, mit einem zu strukturierendes Objekt und mit einer Justiereinheit zur Positionierung des Objektes in einem Röntgenstrahl und zur Ausrichtung des Objektes relativ zur Maske, **gekennzeichnet** durch einen zwischen Objekt (W) und Justiereinheit (J) angeordneten Behälter mit elastischen Wandungen, dessen Innendruck variabel und einstellbar ist.

FIG 1

FIG 2

FIG 3